# EUROPEAN PATENT APPLICATION

(11) **EP 2 607 947 A2**
(43) Date of publication of application: **26.06.2013**
(21) Application number: 12197814.2
(22) Date of filing: 18.12.2012
(51) Int. Cl.: G02F 1/1333

(54) **Display apparatus with an electromagnetic wave shielding structure**

(30) Priority: 22.12.2011 KR 20110140113
(71) Applicant: Samsung Electronics Co., Ltd., Gyeonggi-do 443-742 (KR)
(72) Inventor: Lee, Woong Hee, Gyeonggi-do (KR); Kan, Woo Young, Gyeonggi-do (KR); Park, Doo Soon, Gyeonggi-do (KR); Jung, Sung Soo, Gyeonggi-do (KR); Jung, Hyun Jun, Gyeonggi-do (KR)
(74) Representative: Clark, David James

(57) **Abstract**

A display apparatus having an electromagnetic wave shielding structure and an electromagnetic wave reducing structure, are provided. The electromagnetic wave shielding and reducing structures are applicable to various materials. The display apparatus includes a display panel, a rear case disposed at a rear of the display panel and formed of a nonconductive material, a printed circuit board disposed at a rear of the rear case, and an electromagnetic wave reducer provided at one surface of the rear case and being formed of a conductive material to reduce the electromagnetic wave generated at the printed circuit board, wherein the electromagnetic wave reducer is electrically connected to the printed circuit board.

## Description

### BACKGROUND

### 1. Field

Exemplary embodiments of the inventive concept relate to a display apparatus having an electromagnetic wave shielding structure which is capable of shielding an electromagnetic wave generated inside the display apparatus.

### 2. Description of the Related Art

In general, a display apparatus is an apparatus which is configured to display an image on a surface of a display panel in a visual manner, and is provided with various electronic components such as circuit elements mounted thereon in order to drive the display apparatus.

Thus, in a case of a display apparatus being operated, an electromagnetic wave is generated at the electronic components which are inside the display apparatus. The electromagnetic wave causes electromagnetic interference (EMI) to occur at the electronic components which are inside the display apparatus. As a result, a malfunction of the display apparatus may occur.

In addition, in a case where the electromagnetic wave generated inside the display apparatus is emitted outside the display apparatus without being shielded, the electromagnetic wave may cause electromagnetic interference with other electronic apparatuses, and the electromagnetic wave emitted to the outside of the display apparatus may affect the body of a user.

Recently, as the significance of design has emerged, the display apparatus uses various exterior trims as the display apparatus is further formed with a compact structure. Thus, a need exists for developing a structure which is configured to shield a magnetic wave and reduce the generated electromagnetic wave and to shield the electromagnetic wave from being emitted outside of the display apparatus, such that the display apparatus is formed in a compact structure and uses the various exterior trims.

### SUMMARY

Therefore, it is one aspect of the inventive concept to provide a display apparatus having an electromagnetic wave shielding structure and an electromagnetic wave reducing structure which is applicable to various materials.

It is another aspect of the inventive concept to provide a display apparatus having an electromagnetic wave shielding structure and an electromagnetic wave reducing structure which provides large economic value.

Additional aspects of the inventive concept will be set forth in part in the description which follows and, in part, will be obvious from the description, or may be learned by practice of the exemplary embodiments.

In accordance with one aspect of the exemplary embodiments, a display apparatus includes a display panel, a rear case, a printed circuit board, an electromagnetic wave reducer. The rear case may be disposed at a rear of the display panel and formed of a non-conductive material. The printed circuit board may be disposed at a rear of the rear case. The electromagnetic wave reducer may be provided at one surface of the rear case and may be formed of a conductive material in order to reduce the electromagnetic wave generated at the printed circuit board. The electromagnetic wave reducer may be electrically connected to the printed circuit board.

The display apparatus may further include at least one first connecting apparatus which is configured to electrically connect the printed circuit board to the electromagnetic wave reducing member.

The first connecting apparatus may include a first stud, which is installed at the rear case and is configured to be electrically connected to the electromagnetic wave reducer, and a coupling member which is coupled between the printed circuit board and the first stud.

The rear case may be formed with glass material.

The electromagnetic wave reducer may be formed with a metallic layer.

An anti-scattering film may be attached to a surface of the electromagnetic wave reducer in order to prevent scattering of debris from the rear case in a situation where the rear case is damaged.

The electromagnetic wave reducer may be formed with an electromagnetic interference (EMI) sheet, and may be attached to the rear case.

The electromagnetic wave reducer may be attached to a portion of one surface of the rear case, and a film, which is configured to prevent debris from being scattered in a situation where the rear case is damaged, is attached to at least one area of the remaining portion of the one surface of the rear case, the remaining portion to which the electromagnetic wave reducer is not attached.

The display apparatus may further include a cover which is disposed at a rear of the printed circuit board in order to protect the printed circuit board. The electromagnetic wave reducer may be electrically connected to the cover.

The display apparatus may further include at least one second connecting apparatus which is configured to electrically connect the cover to the electromagnetic wave reducer.

The second connecting apparatus may include a second stud, which is installed at the rear case and electrically connected to the electromagnetic wave reducer, and a coupling member which is coupled between the cover and the second stud.

In accordance with another aspect of the exemplary embodiments, a display apparatus includes a display panel, a rear case, a printed circuit board, a cover and a conductive material. The rear case may be formed of a non-conductive material, and may be disposed at a rear portion of the display panel. The printed circuit board may be disposed at a rear portion of the rear case. The cover may be disposed at a rear portion of the printed circuit board in order to protect the printed circuit board. The conductive material may be provided at one surface of the rear case. The conductive material may be electrically connected to the cover and to the printed circuit board.

The display apparatus may further include a first connecting apparatus that may be configured to secure the printed circuit board to the rear case while electrically connecting the printed circuit board to the conductive material.

The display apparatus may further include a second connecting apparatus that may be configured to secure the cover to the rear case while electrically connecting the cover to the conductive material.

The conductive material may be a metallic layer formed at one surface of the rear case. The rear case may be formed with glass material.

An exemplary embodiment may include a display apparatus, including: a rear case; a printed circuit board disposed at a rear portion of a rear case, and an electromagnetic wave reducer provided at one surface of the rear case and formed of a conductive material to reduce electromagnetic waves generated at the printed circuit board. An anti-scattering film may be attached to a surface of the electromagnetic wave reducer. In response to the rear case being damaged, the anti-scattering film may prevent debris of the rear case from being scattered. In addition, the electromagnetic wave reducer may be attached to the rear case and may be formed with an electromagnetic interference (EMI) sheet.

According to another exemplary embodiment, the electromagnetic wave reducer may be attached to a portion of one surface of the rear case, and a film may be attached to at least one area of the remaining portion of the one surface of the rear case to which the electromagnetic wave reducer is not attached. The film may be configured to prevent debris from being scattered in a situation where the rear case is damaged.

According to the present invention there is provided an apparatus and method as set forth in the appended claims. Other features of the invention will be apparent from the dependent claims, and the description which follows.

### BRIEF DESCRIPTION OF THE DRAWINGS

These and/or other aspects of the inventive concept will become apparent and more readily appreciated from the following description of the exemplary embodiments, taken in conjunction with the accompanying drawings of which:
FIG. 1 is an exploded view of a display apparatus in accordance with one exemplary embodiment of the inventive concept.
FIG. 2 is a cross-sectional view of a portion of a display apparatus in accordance with one exemplary embodiment of the inventive concept.
FIG. 3 is a cross-sectional view of a portion of a display apparatus in accordance with another exemplary embodiment of the inventive concept.
FIG. 4 is a cross-sectional view of a portion of a display apparatus in accordance with another exemplary embodiment of the inventive concept.
FIG. 5 is a cross-sectional view of a portion of a display apparatus in accordance with another exemplary embodiment of the inventive concept.

### DETAILED DESCRIPTION

Reference will now be made in detail to the exemplary embodiments of the inventive concept, examples of which are illustrated in the accompanying drawings, wherein like reference numerals refer to like elements throughout.

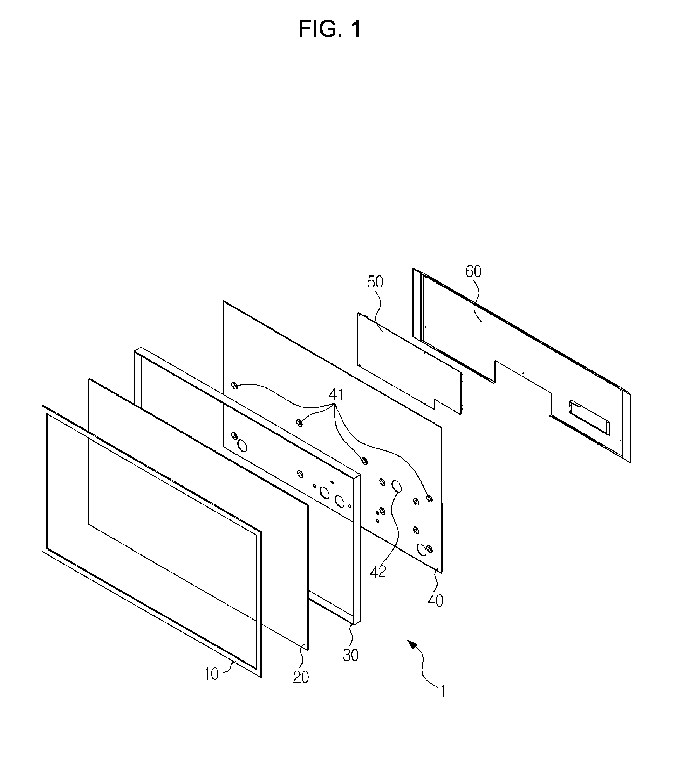

As illustrated on FIG. 1, a display apparatus 1 includes a display module 20 which displays an image; cases 10, 30, and 40 which form an exterior appearance of the display apparatus 1 while covering the display apparatus 1; a printed circuit board 50 which drives the display module 20, and a cover 60 which protects the printed circuit board 50.

The cases 10, 30, and 40 include a front case 10 disposed at an edge portion of the front surface of the display module 20, a rear case 40 disposed at a rear of the display module 20, and a middle case 30 having the display module 20 disposed at a periphery thereof and coupled between the front case 10 and the rear case 40.

The rear case 40, which covers the entire rear surface of the display module 20, may be formed in a panel having a size which corresponds to the display module 20.

The rear case 40 is provided with a plurality of penetrating holes 42 which allows various cables (not shown) configured to deliver an image signal and to supply power to the display module 20, to pass therethrough. The rear case 40 is provided with a plurality of installation holes 41 configured for the installation of the various components such as the printed circuit board 50 and the cover 60, which is disposed at a rear of the rear case 40.

In addition, the rear case 40 may include an heat radiation sheet (not shown) which is configured to induce the heat generated at the display module 20 and the printed circuit board 50, to be radiated outside the rear case 40. The radiation sheet as such may be provided at entire one surface of the rear case 40, or at a portion of an area of the rear case 40.

The printed circuit board 50 is provided with a predetermined circuit pattern formed thereon, and a plurality of circuit devices are installed on the circuit pattern.

The cover 60 is disposed at a rear of the printed circuit board 50, and may be composed to cover an area at which electronic components, as well as the printed circuit board 50, such as a power supply, are installed.

According to the structure illustrated, the front case 10 is installed at the front surface of the display module 20 to form a bezel. However, as the front case 10 is omitted, the middle case 30 may be formed in a way to finish the side surface portion between the display module 20 and the rear case 40.

In addition, the front case 10 and the middle case 30 may be integrally formed with each other to be composed as one case to finish the front surface and the side surface of the display module 20.

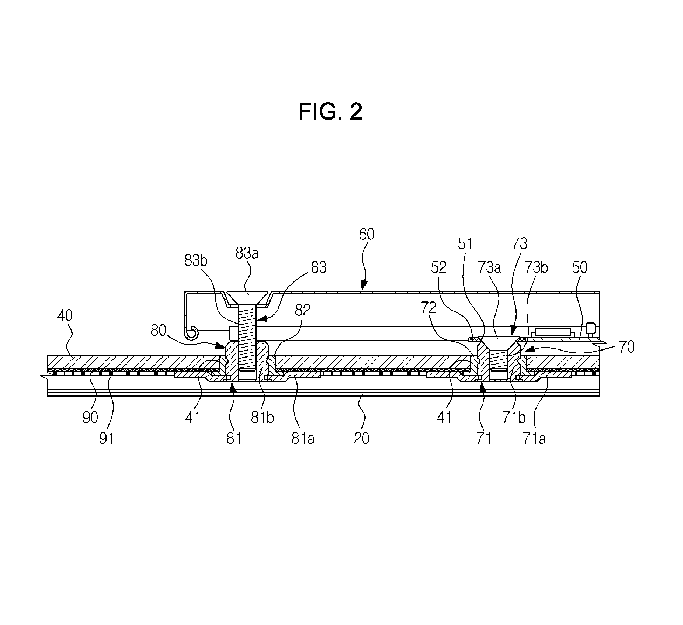

As illustrated on FIG. 2, the rear case 40 is disposed while being spaced apart from the display module 20, and may be formed with tempered glass or plastic resin, both of which are non-conductive material.

At an inner surface of the rear case 40 which corresponds to the display module 20, an electromagnetic wave reducer 90 composed of non-conductive material is provided.

The electromagnetic wave reducer 90 may be a metallic layer which is formed by depositing metal such as stainless steel, or may be formed of pre-processed metal foil or a metallic panel such as ion plate or copper plate. The electromagnetic wave reducer 90 as such may be provided at an entire area of the inner surface of the rear case 40, or may be provided at a portion of the inner surface of the rear case 40.

In a situation of the exemplary embodiment as illustrated, the rear case 40 is composed of glass, and an anti-scattering film 91 is attached at an outer surface of the electromagnetic wave reducer 90 in preparation for a situation where the rear case 40 is damaged by a physical impact.

In a situation where the rear case 40 is damaged, the anti-scattering film 91 is configured to prevent the scattering of the debris by applying certain protection with respect to the debris, and furthermore, prevents the rear case 40 from being perforated so that the display module 20 located at an inner side of the rear case 40 is protected. The anti-scattering film 91 may be provided to cover an entire inner surface of the rear case 40. Thus, in a situation where the electromagnetic wave reducer 90 is provided only at a portion of an area of an inner surface of the rear case 40, the anti-scattering film 91 may be directly attached at the inner surface of the rear case 40 with respect to an area of the inner surface of the rear case 40 at which the electromagnetic wave reducer 90 is not provided.

A first connecting apparatus 70 is provided between the rear case 40 and the printed circuit board 50. The first connecting apparatus 70, is configured to support the printed circuit board 50 to have the printed circuit board 50 fixed while spaced apart from the rear case 40, and at the same time, is configured to electrically connect between the printed circuit board 50 and the electromagnetic wave reducer 90.

The first connecting apparatus 70 may include a stud 71 installed at the rear case 40, and a coupling member 73 coupled between the printed circuit board 50 and the stud 71.

At the rear case 40, the installation hole 41 is provided so that the stud 1 may be installed at the rear case 40, and at the installation hole 41, a reinforcing member 72 is installed to supplement the strength and the mechanical characteristic of the installation hole 41.

The stud 71 is disposed at an inner side of the rear case 40, and includes flange 71a and a pillar 81b which are configured to penetrate an inner and an outer portion of the rear case 40 through the installation hole 41.

The flange 71a, in a state where stud 71 is installed at the installation hole 41, is configured to support the pillar 71b while forming the contact surface with the electromagnetic wave reducer 90, and enables the stud 71 to be electrically connected to the electromagnetic wave reducer 90.

The coupling member 73 may be composed of a bolt having a head 73a and a screw 73b. While in a state of the coupling member 73 being installed, the head 73a is connected to a linker 52 while being coupled to a hole 51 of the printed circuit board 50, and also the screw 73b is coupled to a screw hole formed at the pillar 71b of the stud 71.

The anti-scattering film 91 may be eliminated from an area between the flange 71a and the electromagnetic wave reducer 90 so that the flange 71a of the stud 71 may be connected to the electromagnetic wave reducer 90.

According to FIG. 2, the one first connecting apparatus 70, as illustrated, connects between the printed circuit board 50 and the rear case 40. However, the above is provided as one example of a connecting relationship between the printed circuit board 50 and the rear case 40;, and a plurality of first connecting apparatuses 70 may be installed between the printed circuit board 50 and the rear case 40.

In addition, a second connecting apparatus 80 is installed between the cover 60 and the rear case 40. The second connecting apparatus 80 as a whole is composed in a similar manner to the first connecting apparatus 70, and may include a stud 81 installed at the rear case 40, and may include a coupling member 83 coupled between the cover 60 and the stud 81.

The stud 81, to be compatible with the first connecting apparatus 70, may be formed similar to the stud 71 of the first connecting apparatus 70. However, in a situation where the coupling member 83, by considering that the distance up to the cover 60 disposed at a rear of the printed circuit board 50 from the rear case 40 is longer than the distance up to the printed circuit board 50 from the rear case 40, the length of the coupling member 83 is formed to be longer than the coupling member 73 of the first connecting apparatus 70.

At the rear case 40, the installation hole 41 is provided so that the stud 81 may be installed at the rear case 40, and at the installation hole 41, a reinforcing member 82 is installed to supplement the strength and the mechanical characteristic of the installation hole 41. The installation hole 41 as such may be composed in a similar manner to the installation hole 41 that is configured for the installation of the first connecting apparatus 70.

The stud 81 is disposed at an inner side of the rear case 40, and includes a flange 81a and a pillar 81b which are configured to penetrate an inner and an outer portion of the rear case 40 through the installation hole 41.

The coupling member 83 may be composed of a bolt having a head 83a and a screw 83b In a state of the coupling member 83 being installed, the head 83a is connected to the cover 60 while being coupled to a hole of the cover 60, and also the screw 83b is coupled to a screw hole formed at the pillar 81b of the stud 81.

The cover 60 is formed in a metallic panel, and is configured to block an electromagnetic wave from being discharged outside of the display apparatus 1, and at the same time, may form a grounding structure that is configured to induce the reduction of an electromagnetic wave.

As same as with the first connecting apparatus 70, the anti-scattering film 91 may be eliminated from an area in between the flange 81a and the electromagnetic wave reducer 90 so that the flange 81a of the stud 81 may be connected to the electromagnetic wave reducer 90.

As with the above, as the printed circuit board 50 is electrically connected, respectively, to each of the electromagnetic wave reducer 90 and the cover 60 through the first connecting apparatus 70 and the second connecting apparatus 80, a single circuit configured to reduce the electromagnetic wave being absorbed through the cover 60 and the electromagnetic wave reducing 90 is provided.

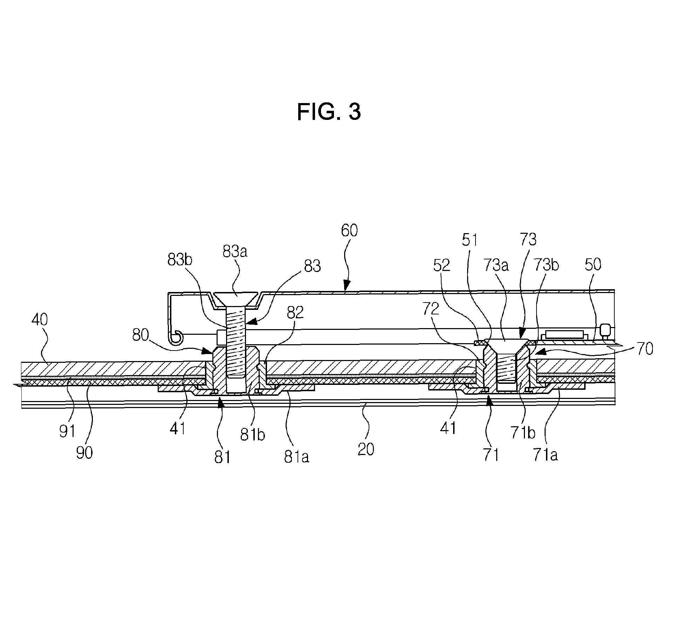

Referring to FIGS. 3 to 4, a display apparatus in accordance with another exemplary embodiment of the inventive concept will be described.

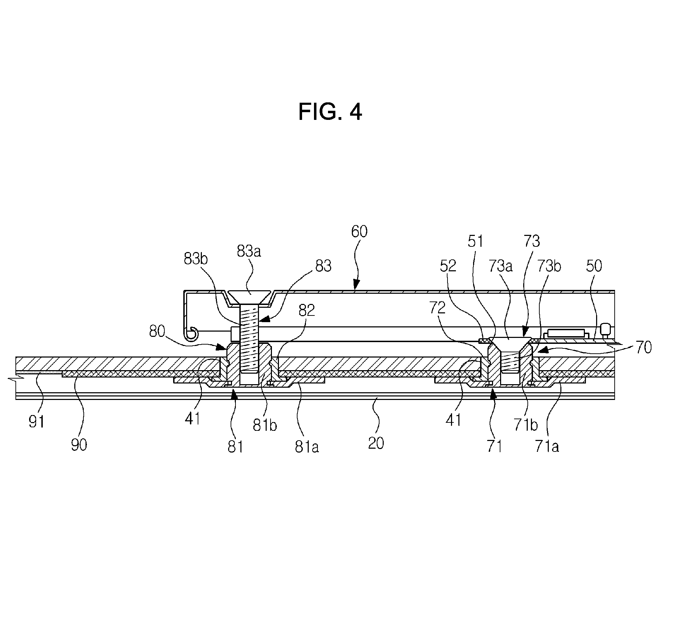

The main difference between the exemplary embodiment of FIGS. 3 and 4 and the exemplary embodiment described above is that the electromagnetic wave reducer 90 is composed of an electromagnetic interference sheet (EMI).

The EMI sheet is referred to as a sheet composed of fiber coated with metal having high electrical conductivity, and the description of the EMI sheet is already known. Thus, the detailed description of the EMI sheet will be omitted.

In a situation when the electromagnetic wave reducer 90 is composed of the EMI sheet, the anti-scattering film 91 is attached to the entire inner surface of the rear case 40; and the EMI sheet is attached to an area, at which the shielding of the electromagnetic wave is determined to be needed, thereby forming the electromagnetic wave reducer 90.

As illustrated in FIG. 4, the anti-scattering film 91 is attached to the inner surface of the rear case 40, but the EMI sheet is attached without attaching the anti-scattering film 91 to an area at which the EMI sheet is to be attached. If the EMI sheet is attached to the rear case 40, the EMI sheet, similar to the anti-scattering film 91, may provide certain protection with respect to the debris in a situation where the rear case 40 is damaged. Thus, the anti-scattering film 91 may serve as the EMI sheet.

As above, in response to the anti-scattering film 91 being selectively attached only at the area at which the EMI sheet is not attached, the use of the anti-scattering film 91 may be reduced to the same extent as the area which corresponds to the area at which the EMI sheet is attached, thereby reducing the manufacturing cost of the display apparatus.

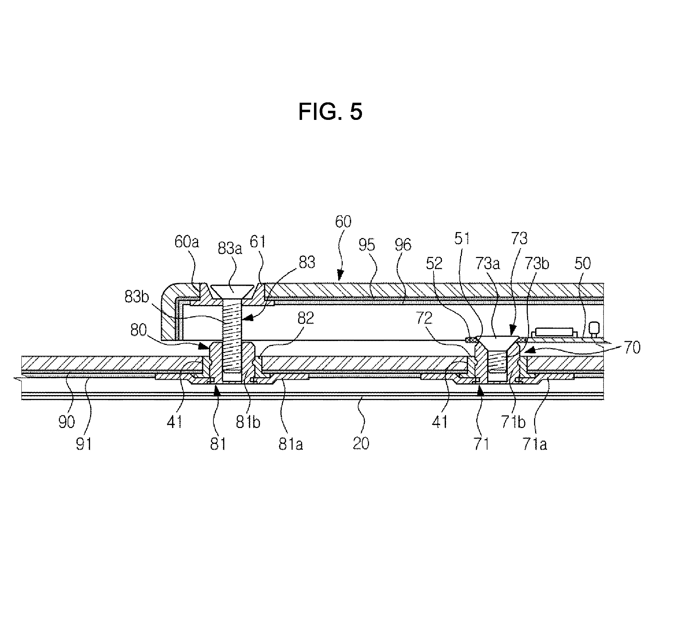

By referring to FIG. 5, a display apparatus in accordance with another exemplary embodiment of the inventive concept will be described.

In a situation of the exemplary embodiment of FIG. 5, the cover 60 may be composed of non-conductive material that is not metallic material. For example, the cover 60 may be composed of glass.

In a situation where the cover 60 is composed of glass, since most of the electromagnetic wave generated at the printed circuit board 60 may not be shielded, but rather is discharged outside of the display apparatus,. Accordingly, at an inner surface of the cover 60, similar to the rear case 40, an electromagnetic wave reducer 95 is provided.

The electromagnetic wave reducer 95, similar to the electromagnetic wave reducer 90, provided at the rear case 40 as described in the earlier exemplary embodiments, may be a metallic layer which are formed by depositing metal such as stainless steel, or may be formed of pre-processed metal foil or a metallic panel such as an ion plate or as a copper plate.

Similar to the situation of the rear case 40, an anti-scattering film 96 configured to prepare for the damage of the cover 60 may be attached on the electromagnetic wave reducer 95, and an installation hole 60a through which the coupling member 83 penetrates is provided at the cover 60. At the installation hole 60a, a reinforcing member 61 is installed to supplement the strength of the installation hole 60a, and the reinforcing member 61 electrically connects between the electromagnetic wave reducer 95 and the coupling member 83.

In addition, similar to the exemplary embodiment above, the electromagnetic wave reducer 95 may be composed of the EMI sheet. In such a situation, on the inner surface area of the cover 60, the remaining area other than the area at which the EMI sheet is attached is provided with the anti-scattering film 96 being selectively attached thereto. Alternatively, the EMI sheet may be attached at the entire inner surface area of the cover 60, and the attachment of the anti-scattering film 96 may be omitted.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A display apparatus, comprising:
a display panel,
a rear case disposed at a rear of the display panel and formed of a non-conductive material,
a printed circuit board disposed at a rear of the rear case, and
an electromagnetic wave reducing unit provided at one surface of the rear case and formed of a conductive material to reduce the electromagnetic wave generated at the printed circuit board,
wherein the electromagnetic wave reducing unit is electrically connected to the printed circuit board.

2. The display apparatus of claim 1, further comprising:
at least one first connecting apparatus configured to electrically connect the printed circuit board to the electromagnetic wave reducing member.

3. The display apparatus of claim 2, wherein:
the at least one first connecting apparatus comprises a first stud, which is installed at the rear case and configured to be electrically connected to the electromagnetic wave reducing unit, and a coupling member coupled between the printed circuit board and the first stud.

4. The display apparatus of claim 1, wherein:
the rear case is formed with glass material.

5. The display apparatus of claim 1, wherein:
the electromagnetic wave reducing unit is formed with a metallic layer.

6. The display apparatus of claim 5, wherein:
an anti-scattering film is attached to a surface of the electromagnetic wave reducing unit to prevent debris of the rear case from being scattered in a case when the rear case is damaged.

7. The display apparatus of claim 1, wherein:
the electromagnetic wave reducing unit is formed with an electromagnetic interference (EMI) sheet, and is attached to the rear case.

8. The display apparatus of claim 7, wherein:
the electromagnetic wave reducing unit is attached to a portion of one surface of the rear case, and a film, configured to prevent debris from being scattered in a situation when the rear case is damaged, is attached to at least one area of the remaining portion of the one surface of the rear case, the remaining portion to which the electromagnetic wave reducing unit is not attached.

9. The display apparatus of claim 1, further comprising:
a cover disposed at a rear of the printed circuit board to protect the printed circuit board, wherein the electromagnetic wave reducing unit is electrically connected to the cover.

10. The display apparatus of claim 9, further comprising:
at least one second connecting apparatus configured to electrically connect the cover to the electromagnetic wave reducing unit.

11. The display apparatus of claim 10, wherein:
the at least one second connecting apparatus comprises a second stud, which is installed at the rear case and electrically connected to the electromagnetic wave reducing unit, and a coupling member coupled between the cover and the second stud.
